# EUROPÄISCHE PATENTSCHRIFT

(11) **EP 1 642 335 B1**
(45) Veröffentlichungstag und Bekanntmachung des Hinweises auf die Patenterteilung: **13.08.2008**
(21) Anmeldenummer: 04741804.1
(22) Anmeldetag: 15.06.2004
(51) Int. Cl.: H01L 23/473, H01L 23/427, H01L 21/3063

(54) **INTEGRIERTE KÜHL-SCHALTUNGSANORDNUNG, BETRIEBSVERFAHREN UND HERSTELLUNGSVERFAHREN**
INTEGRATED COOLANT CIRCUIT ARRANGEMENT, OPERATING METHOD AND PRODUCTION METHOD
ENSEMBLE CIRCUIT INTEGRE A REFROIDISSEMENT ET PROCEDE DE FABRICATION DUDIT ENSEMBLE

(30) Priorität: 08.07.2003 DE 10330731
(43) Veröffentlichungstag der Anmeldung: 05.04.2006
(73) Patentinhaber: Infineon Technologies AG, 81669 München (DE)
(72) Erfinder: LEHMANN, Volker, 80689 München (DE); STENGEL, Reinhard, 86391 Stadtbergen (DE); SCHÄFER, Herbert, 85635 Höhenkirchen-Siegertsbrunn (DE)
(74) Vertreter: Kindermann, Peter
(86) Internationale Anmeldenummer: PCT/EP2004/051116
(87) Internationale Veröffentlichungsnummer: WO 2005/006436

(56) Entgegenhaltungen:
- EP-A- 1 289 012
- WO-A-00/75764
- US-A- 5 403 752
- US-A- 5 998 240
- US-B1- 6 228 744
- US-B1- 6 242 778
- OTTOW S ET AL: "Development of three dimensional microstrcture processing using macroporous n-type silicon" APPLIED PHYSICS A: MATERIALS SCIENCE & PROCESSING, SPRINGER INTERNATIONAL, DE, Bd. 63, 1996, Seiten 153-159, XP002285150 ISSN: 0947-8396

## Beschreibung

Die Erfindung betrifft eine Schaltungsanordnung mit einem Substrat, dessen Oberfläche eine Hauptfläche bildet. Außerdem enthält die Schaltungsanordnung eine Vielzahl von an der Hauptfläche angeordneten integrierten elektronischen Bauelementen. Die Bauelemente sind im Fall von sogenannten Bulk-Bauelementen im Substrat angeordnet und im Fall der Verwendung der sogenannten SOI-Technik (Silicon On Insulator) durch ein festes elektrisch isolierendes Gebiet vom Substrat getrennt. Außerdem enthält das Substrat eine Vielzahl von im Substrat ausgebildeten Hauptkanälen, die entlang der Hauptfläche angeordnet sind, insbesondere mit ihren Längsachsen parallel zur Hauptfläche.

Eine solche Kühl-Schaltungsanordnung ist beispielsweise aus dem US-Patent 4,450,472 bekannt. Die dort erläuterte Schaltungsanordnung enthält parallel zueinander ausgerichtete Kühlgräben, die in einen Chip geätzt worden sind und in denen ein Kühlmittel transportiert wird. Die Gräben sind mit einer Deckplatte bedeckt, so dass Kanäle entstehen. Als Kühlmittel wird Wasser verwendet. Das Wasser wird mit Hilfe einer äußeren Pumpe durch die Kühlkanäle gepumpt.

Weitere Kühl-Schaltungsanordnungen sind aus den Druckschriften US-6228744, US-6242778, US5998240 und WO-A-0075764 bekannt.

Es ist Aufgabe der Erfindung, eine verbesserte integrierte Kühl-Schaltungsanordnung anzugeben, insbesondere hinsichtlich der Kühleigenschaften und insbesondere hinsichtlich der einfachen Herstellbarkeit. Außerdem sollen Betriebsverfahren für die Kühl-Schaltungsanordnung und ein Herstellungsverfahren angegeben werden.

Die auf die Schaltungsanordnung bezogene Aufgabe wird durch eine Schaltungsanordnung mit den im Patentanspruch 1 angegebenen Merkmalen gelöst. Weiterbildungen sind in den Unteransprüchen angegeben.

Die Erfindung geht von der Überlegung aus, dass die Wärme direkt an den im oder am Substrat angeordneten Halbleiterbauelementen entsteht und auch von dort großflächig abgeführt werden sollte. Deshalb werden bei der erfindungsgemäßen Schaltungsanordnung Hauptkanäle beibehalten, die in dem Substrat angeordnet sind.

Weiterhin geht die Erfindung von der Überlegung aus, dass das Substrat eine Dicke hat, die ausreicht, um die Kühlkanäle vollständig im Substrat auszubilden. Bei der erfindungsgemäβen Schaltungsanordnung werden deshalb die Hauptkanäle so ausgebildet, dass sie quer zu ihrer Längsachse vollständig von dem Substrat umgeben sind. Dies hat zur Folge, dass eine zusätzliche Abdeckplatte und die damit verbundenen Herstellungsschritte nicht erforderlich sind. Andererseits wird die mechanische Stabilität des Substrats beibehalten. Durch das vollständige Umgeben der Hauptkanäle mit Substrat wird außerdem der Querschnitt der Hauptkanäle geringer, so dass die Möglichkeit besteht, Kapillarkräfte zum Transport des Kühlmediums einzusetzen.

Bei einer Weiterbildung der erfindungsgemäßen Schaltungsanordnung gibt es eine Vielzahl von quer zu den Hauptkanäle angeordneten Querkanälen, die jeweils in mindestens einen Hauptkanal münden. Beispielsweise münden mehr als zehn Querkanäle, oder mehr als hundert Querkanäle in einen Hauptkanal. Durch das Verwenden von Hauptkanälen und Querkanälen lassen sich die Querschnittsflächen dieser Kanäle unabhängig voneinander wählen, so dass die Querschnitte optimal auf die verwendete Kühlart, z.B. Kühlung mit oder ohne Phasenübergang zwischen flüssiger und gasförmiger Phase, und das verwendete Kühlmedium abgestimmt werden können.

Bei einer Ausgestaltung haben die Querkanäle eine Länge größer als 100 µm oder größer als 200 µm, insbesondere haben die Querkanäle eine Länge, die mehr als 3/4 der Dicke des Substrats beträgt. Durch diese Maßnahme kann das Kühlmedium nahe an die aktiven Bauelemente in den Querkanälen herantransportiert werden oder alternativ von einem Ort nahe der aktiven Bauelemente, d.h. von einem heißen Ort mit Temperaturen von bspw. über 100 °C, durch die Querkanäle nach außen transportiert werden. Die Querkanäle sind im Vergleich zu den Hauptkanälen außerdem wesentlich kürzer und haben beispielsweise nur eine Länge, die kleiner als 1/10 oder kleiner als 1/20 der Länge eines Hauptkanals ist. Mit zunehmendem Waferdurchmesser wird auch die Substratdicke größer. So sind bei 300 mm Wafern Querkanäle mit einer Länge von über 650 µm vorhanden.

Bei einer nächsten Weiterbildung sind die Längsachsen der Hauptkanäle parallel zueinander ausgerichtet. Die Längsachsen der Querkanäle sind ebenfalls parallel zueinander ausgerichtet. So angeordnete Quer- und Hauptkanäle lassen sich auf einfache Art mit den für integrierte Schaltungsanordnungen geeigneten Herstellungsverfahren erzeugen, beispielsweise mit Hilfe von Ätzverfahren. Bei einer Ausgestaltung liegen die Längsachsen der Querkanäle vorzugsweise in Normalenrichtung der Hauptfläche mit den aktiven Bauelementen.

Bei einer nächsten Weiterbildung haben einander gegenüberliegende Seiten eines Hauptkanals bzw. aller Hauptkanäle einen Abstand kleiner als 40 µm oder kleiner als 10 µm. Bei einer Ausgestaltung ist der Abstand entlang des gesamten Hauptkanals kleiner als die genannten Maße. Aufgrund der kleinen Abmessungen des Hauptkanals kann der Hauptkanal ein Kühlmedium über Kapillarkräfte transportieren, insbesondere über Strecken von mehreren Millimetern oder sogar über eine Strecke von mehreren Zentimetern.

Bei einer alternativen Weiterbildung haben einander gegenüberliegende Seiten eines Querkanals bzw. aller Querkanäle einen Abstand kleiner als 40 µm oder kleiner als 10 µm, vorzugsweise entlang des gesamten Querkanals. Durch diese Maßnahme sind die Querkanäle zum Transport des Kühlmediums aufgrund von Kapillarkräften geeignet.

Durch den Transport des Kühlmediums mittels Kapillarkräften ist keine zusätzlich zu den Kanälen auszubildende Pumpe erforderlich, insbesondere keine Pumpe mit beweglichen Teilen oder eine Pumpe, die mit Hilfe von elektrischem Strom gespeist werden muss. somit tritt kein Verschleiß von sich bewegenden Teilen auf.

Bei einer nächsten Weiterbildung ist der minimale Abstand zwischen den Rändern einander benachbarter Hauptkanäle kleiner als 40 µm oder kleiner als 20 µm oder kleiner als 10 µm. Bei einer zusätzlichen oder alternativen Weiterbildung ist auch der Abstand zwischen den Rändern einander benachbarter Querkanäle kleiner als 40 µm oder kleiner als 20 µm oder kleiner als 10 µm. Durch die Wahl dieser Abstände wird gewährleistet, dass das Substrat engmaschig von Querkanälen bzw. Hauptkanälen durchzogen ist und somit eine große Fläche für die Übertragung von Wärme zwischen dem Substrat und dem Kühlmedium in den Kanälen vorhanden ist. Die gewählten Abstände sind jedoch nicht so klein, dass die Stabilität des Substrats oder die Stabilität der Wände der Querkanäle bzw. der Hauptkanäle übermäßig beeinträchtigt wird. insbesondere sind die minimalen Abstände größer als 1 µm oder Größer als 3 µm.

Bei einer nächsten Weiterbildung liegen die Ränder der Hauptkanäle weniger als 50 µm (Mikrometer) oder weniger als 10 µm von der Hauptfläche entfernt. Enthält die Schaltungsanordnung kein tiefen Gräben, so werden die Hauptkanäle bei einer Ausgestaltung bis auf weniger als 5 µm oder sogar bis auf weniger als 2 µm an die Hauptfläche herangeführt.

Beim Einsatz von Silizium ergeben sich durch einen geringen Abstand zwischen den aktiven Bauelementen und den Hauptkanälen wärmetechnisch Vorteile. Beispielsweise kann Temperaturspitzen besser entgegengewirkt werden.

Bei einer nächsten Weiterbildung ist das Substrat von einem Gehäuse umgeben, in dem sich ein flüssiges Kühlmedium befindet. Im Betrieb der integrierten Schaltungsanordnung ist das flüssige Kühlmedium bei einer Ausgestaltung zum Teil im gasförmigen Zustand.

Bei einer nächsten Weiterbildung mit Gehäuse für ein flüssiges Kühlmedium haben die Hauptkanäle oder die Querkanäle einen so kleinen Durchmesser, dass das Kühlmedium durch Kapillarkräfte transportiert wird. Durch diese Maßnahme ist keine zusätzliche Pumpe erforderlich, die einem Verschleiß unterliegt und die zusätzliche Herstellungsschritte erfordert.

Bei einer Ausgestaltung hat die jeweils andere Kanalart einen Querschnitt, der den Austritt von gasförmigem Kühlmedium aus dem Substrat erlaubt. Insbesondere haben bei Hauptkanälen mit Kapillarwirkung die Querkanäle die gleiche Querschnittsfläche wie die Hauptkanäle oder eine größere Querschnittsfläche als die Hauptkanäle. Alternativ können auch bei Hauptkanälen mit Kapillarwirkung die Querkanäle einen kleineren Querschnitt als die Hauptkanäle haben.

Bei Querkanälen mit Kapillarwirkung sind die Hauptkanäle bei einer Ausgestaltung mit einem größeren Querschnitt versehen als die Querkanäle. Damit kann das aus einer Vielzahl von Querkanälen in einen Hauptkanal eintretende Kühlmedium im Hauptkanal aus dem Substrat gut entweichen, insb. gasförmig. Beispielsweise hat der Hauptkanal einen Querschnitt, der mindestens das Zehnfache des Querschnitts eines Querkanals beträgt.

Aufgrund des Verwendens der Kapillarwirkung zum Transport des Kühlmediums enthält das Gehäuse keine Pumpe zum Transport des Kühlmittels und auch keine Öffnungen zum Eintritt oder Austritt eines Kühlmittels, das von einer Pumpe kommt oder zu einer Pumpe transportiert wird.

Bei einer anderen Weiterbildung enthält das Gehäuse eine Kondensiervorrichtung, die gasförmiges Kühlmedium kondensiert, insbesondere eine gekühlte Kondensierfläche. Durch die Kombination von Kapillarwirkung und von einem Phasenübergang des Kühlmittels wird das sogenannte heatpipe-Prinzip genutzt, bei dem eine Wärmeleitfähigkeit erreicht wird, die die Wärmeleitfähigkeit des Kupfers um mehrere Größenordnungen übersteigt.

Bei einer anderen Weiterbildung wird jedoch ein Pumpsystem zum Transport des Kühlmittels eingesetzt. Besonders geeignet sind osmotische Pumpen oder elektrokinetische Pumpen. Der Kühlkreislauf enthält auch beim Betrieb der Schaltungsanordnung bspw. nur flüssiges Kühlmittel. Bei einer Ausgestaltung wird das flüssige Kühlmedium in die Querkanäle gepumpt. Beim Erreichen der Hauptkanäle verdampft das Kühlmedium. Mit Hilfe eines Kondensors wird das dampfförmige Kühlmedium wieder verflüssigt und zur Pumpe geleitet. Umgekehrt wird das Kühlmittel bei einer anderen Ausgestaltung in die Hauptkanäle gepumpt, wo es an den Querkanälen und durch die Querkanäle verdampft.

Bei einer nächsten Weiterbildung enthält das Substrat als Grundmaterial Silizium, d.h. ein Material, für das eine Vielzahl von Bearbeitungsmethoden bekannt ist. Insbesondere von Bearbeitungsmethoden die zum Erzeugen der Hauptkanäle und der Querkanäle geeignet sind. So ist n-dotiertes Siliziumsubstrat für eine elektrochemische Herstellung der Querkanäle und der Hauptkanäle geeignet. In diesem Zusammenhang wird auf das Buch "Electrochemistry of Silicon" des Miterfinders V. Lehmann verwiesen, das im Verlag VCH Wiley, 2002, erschienen ist.

Eine andere Möglichkeit zum Herstellen insbesondere der Querkanäle sind das sogenannte Bosch-Verfahren, beispielsweise gemäß DE 19 706 682 A1 bzw. gemäß DE 42 41045 C1. Zur Herstellung der Hauptkanäle lässt sich nach dem Ätzen der Querkanäle beispielsweise ein Ätzverfahren gemäß WO 99/49506 einsetzen.

Die Erfindung betrifft außerdem zwei Verfahren zum Betreiben der erfindungsgemäßen Schaltungsanordnung oder einer ihrer Weiterbildung. Gemäß dem einen Betriebsverfahren wird die Kühlflüssigkeit durch Kapillarkräfte in den Querkanälen transportiert. Aus den Hauptkanälen tritt verdampftes Kühlmittel aus. Bei der anderen Betriebsweise wird dagegen das flüssige Kühlmittel in den Hauptkanälen aufgrund von Kapillarkräften transportiert und aus den Querkanälen tritt Kühlmitteldampf aus. Beide Betriebsarten arbeiten gemäß dem heatpipe-Prinzip und arbeiten ohne äußere Pumpen.

Die Erfindung betrifft außerdem ein Verfahren zum Herstellen einer integrierten Kühl-Schaltungsanordnung Gemäß Anspruch 12.

Bei einer Weiterbildungen werden die integrierten elektronischen Bauelemente nach dem Einbringen der Hauptkanäle und der Querkanäle in oder an der Hauptfläche erzeugt. Durch diese Maßnahme wird der empfindliche aktive Bereich der integrierten Schaltungsanordnung nicht durch die Herstellungsschritte zum Herstellen der Hauptkanäle und der Querkanäle beeinträchtigt. Die Öffnungen der Hauptkanäle und der Querkanäle werden bei einer nächsten Weiterbildung vor dem Erzeugen der integrierten elektronischen Bauelemente verschlossen. Durch diese Maßnahme können die Hauptkanäle und die Querkanäle nicht durch Prozesse zum Herstellen der integrierten Bauelemente verstopfen. Beispielsweise wird über die Öffnungen der Hauptkanäle und der Querkanäle eine Opferschicht gesputtert, die nach dem Herstellen der integrierten Bauelemente wieder weggeätzt wird, insbesondere selektiv zum Substrat.

Bei einer anderen Weiterbildung werden zuerst die Querkanäle hergestellt. Die Hauptkanäle werden danach durch Aufweitung der Querkanäle erzeugt, vorzugsweise in einem elektrochemischen Abtragungsprozess oder in einem Ätzprozess. Auf die oben genannten elektrochemischen Verfahren und Ätzverfahren wird verwiesen. Durch diese Maßnahme werden Justierungsprobleme beim Erzeugen der Hauptkanäle und der Querkanäle umgangen. Außerdem lässt sich ein Abtragungsprozess oder ein Ätzprozess mit einem fotolithografischen Schritt zum Herstellen beider Kanalarten anwenden. Vorzugsweise werden die Verfahren zum Herstellen der Querkanäle und der Ätzkanäle jeweils in einer Prozesskammer durchgeführt.

Bei einer nächsten Weiterbildung werden die Hauptkanäle und die Querkanäle nach dem Ausbilden der Mündungen gleichzeitig aufgeweitet, um beispielsweise die Querschnittsfläche auf eine optimale Querschnittsfläche zu vergrößern und ohne beispielsweise das Verhältnis der Querschnitte von Hauptkanälen zu den Querschnitten der Querkanäle zu stark verändern.

Bei einer nächsten Weiterbildung wird zum Ausbilden der Hauptkanäle und der Querkanäle Flusssäure in einem elektrochemischen Ätzverfahren verwendet. Das Substrat ist vorzugsweise ein Siliziumsubstrat mit einer n-Dotierung. Während des Ätzens wird das Substrat an ein positiveres Potential als die Flusssäure angelegt. Über die n-Dotierung des Siliziumsubstrats lässt sich der Durchmesser der Querkanäle festlegen. Die Lage der Querkanäle wird durch die Lage der angeätzten Bereiche festgelegt. In den angeätzten Bereichen entstehen beim elektrochemischen Ätzen Feldspitzen, die zu einem hohen lokalen Materialabtrag führen. Solche Verfahren sind in dem oben erwähnten Buch "Electrochemistry of Silicon" von V. Lehmann, näher erläutert.

Im Folgenden werden Ausführungsbeispiele der Erfindung an Hand der beiliegenden Zeichnungen näher erläutert. Darin zeigen:
- Figur 1: eine Prinzipdarstellung der Wärmeableitung in einer integrierten Schaltungsanordnung,
- Figur 2: eine integrierte Schaltungsanordnung mit dicken Hauptkanälen und dünnen Querkanälen,
- Figur 3: eine integrierte Schaltungsanordnung in einem pumpenfreien Kühlsystem, und
- Figuren 4A und 4B: Herstellungsstufen bei der Herstellung von Querkanälen und Hauptkanälen.

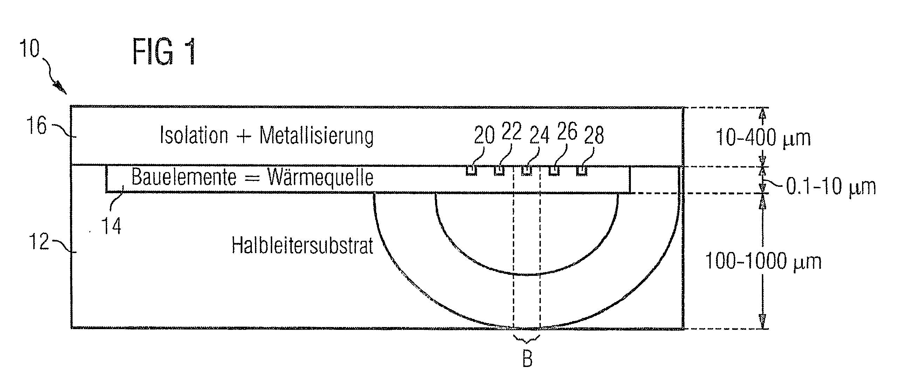

Figur 1 zeigt eine Prinzipdarstellung der Wärmeableitung in einer integrierten Schaltungsanordnung 10, die ein Halbleitersubstrat 12 aus beispielsweise Silizium, einen aktiven Bereich 14 im Substrat 12 sowie mehrere Metallisierungs- und Isolationslagen 16 enthält.

Das Halbleitersubstrat 12 hat beispielsweise eine Dicke zwischen 100 und 1000 µm. Der aktive Bereich 14 enthält eine Vielzahl von aktiven elektronischen Bauelementen, z.B. Transistoren, von denen in Figur 1 fünf Bauelemente 20 bis 28 dargestellt sind. Der aktive Bereich 14 hat beispielsweise eine Dicke von 0,1 bis 10 µm.

Die Metallisierungs- und Isolationslagen 16 enthalten beispielsweise vier Metallisierungsebenen, zwischen denen sich jeweils eine Schicht aus Isoliermaterial befindet. Die Metallisierungs- und Isolierlagen 16 haben beispielsweise eine Gesamtdicke zwischen 10 bis 400 µm.

Der Großteil der Wärmeableitung erfolgt über das Substrat 12, da das Silizium die Wärme etwa hundert mal besser leitet als Siliziumdioxid, das bspw. das Hauptmaterial in den Metallisierungs- und Isolierlagen 16 bildet. Die Wärmeerzeugung in integrierten Schaltungsanordnungen und die ungenügende Wärmeableitung beschränken mit ansteigender elektrischer Leistungsdichte und Integrationsdichte die Performance von Prozessoren und von Hochfrequenzbaugruppen. Methoden zur Kühlung und Wärmeableitung bei Halbleiterbauelementen in integrierten Schaltkreisen oder auch bei Einzelhalbleiterbauelementen werden deshalb vor allem auch für Erhaltung der Zuverlässigkeit immer wichtiger. Die Kühlung ist dabei um so effektiver, je näher das Kühlmedium an die Wärmequelle gebracht werden kann, da mit steigender Integrationsdichte der Wärmewiderstand des Substrats proportional zur Anzahl der in der Bauelemente-Schicht verteilten Wärmequellen zunimmt. Während die Wärme des am Rand liegenden Bauelementes 28 noch sphärisch nach außen abgeleitet werden kann, muss die Wärme eines weiter in der Mitte liegenden Bauelementes über einen entsprechend kleineren Bereich B nach unten abgeleitet werden. Dabei ist zu beachten, dass die in Figur 1 dargestellten Verhältnisse nur eine sehr grobe Näherung sind. Wegen der guten Wärmeleitfähigkeit von z.B. Silizium kommt es damit vor allem darauf an, die jedem Bauelement zur Verfügung stehende "Kühloberfläche" so groß wie möglich zu machen.

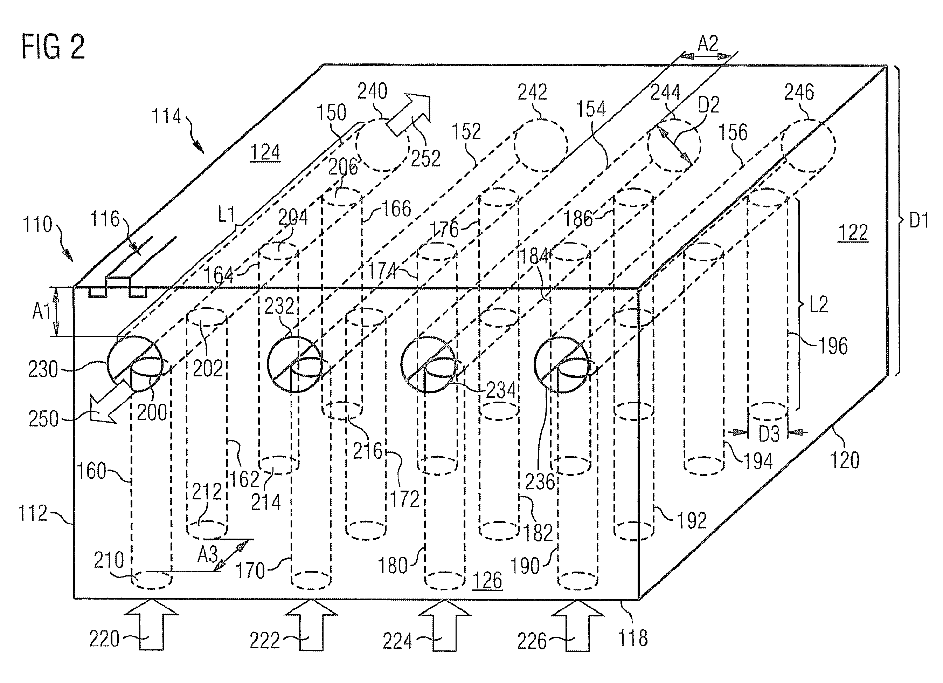

Figur 2 zeigt eine integrierte Schaltungsanordnung 110 in einem Siliziumsubstrat 112. Das Siliziumsubstrat 112 ist nach dem Vereinzeln einzelner Chips quaderförmig. Eine Vielzahl von integrierten Bauelementen befindet sich in einer Deckfläche 114 des Siliziumsubstrats 112, wie beispielsweise einem MOS-Transistor 116 (Metall Oxide Semiconductor). Die Deckfläche 114 wird von vier Seitenflächen 118 bis 124 begrenzt. Die Seitenflächen 118 bis 124 enden an einer unter der Deckfläche 114 angeordneten Bodenfläche 126 des Siliziumsubstrats 112. Eine Dicke D1 des Siliziumsubstrats 112 beträgt im Ausführungsbeispiel 725 µm.

Im Abstand A1 bei beispielsweise 10 µm liegen obere Ränder einer Vielzahl von parallel zueinander angeordneten Hauptkanälen, von denen in Figur 2 vier Hauptkanäle 150 bis 156 dargestellt sind. Die Hauptkanäle 150 bis 156 haben beispielsweise kreisrunde Querschnitte mit einem Durchmesser D2 von beispielsweise etwa 20 µm. Eine Länge L1 der Hauptkanäle 150 bis 156 beträgt jeweils beispielsweise 1 cm. Die Hauptkanäle 150 bis 156 sind in einer Ebene aufgereiht, die parallel zur Deckfläche 114 liegt. Die Abstände zwischen benachbarten Hauptkanälen sind gleich. So beträgt ein Abstand A2 zwischen den Rändern einander benachbarter Hauptkanäle 152, 154 beispielsweise 10 µm.

Von der Bodenfläche 126 aus erstrecken sich eine Vielzahl von Querkanälen zur Deckfläche 114 hin. Die Querkanäle sind in Reihen unterhalb jeweils eines Hauptkanals aufgereiht. In Figur 2 sind vier Querkanäle 160 bis 166 unter dem Hauptkanal 150, vier Querkanäle 170 bis 176 unter dem Hauptkanal 152, vier Querkanäle 180 bis 186 unter dem Hauptkanal 150 und vier Querkanäle 190 bis 196 unterhalb des Hauptkanals 156 dargestellt. Die unterhalb eines Hauptkanals 150 bis 156 liegenden Querkanäle münden in den betreffenden Hauptkanal ein, siehe beispielsweise die Querkanäle 160 bis 166, die in den Hauptkanal 150 münden, siehe Mündungen 200 bis 206. Die Querkanäle 160 bis 196 haben somit eine Länge L2 von 695 µm bis zu einem deckflächenfernen Ende der Mündungen 200 bis 206. Ein Durchmesser D3 der Querkanäle 160 bis 166 beträgt beispielsweise 10 µm. Ein Abstand A3 zwischen benachbarten Querkanälen 160, 162 einer Reihe aus Querkanälen beträgt beispielsweise ebenfalls 10 µm.

Bei einem anderen Ausführungsbeispiel haben die Querkanäle einen Durchmesser von 1 bis 10 µm und einen Abstand A3 von 1 bis 20 µm sowie eine Länge von 100 bis 1000 µm. Die Querkanäle 160 bis 196 führen bei einem ersten Ausführungsbeispiel in einem Kühlkreislauf mit Wärmeaustauscher und Pumpe das Kühlmedium bis zu einigen Mikrometern unterhalb der elektronischen Bauelemente 116, siehe Eintrittsöffnungen 210 bis 216 sowie Pfeile 220 bis 226. Nach dem Austritt des Kühlmediums aus den Querkanälen 160 bis 196 wird das Kühlmedium in den Hauptkanälen 150 bis 156 unterhalb der Deckfläche 114 entlang zu Austrittsöffnungen 230 bis 246 in der Seitenfläche 118 bzw. in der Seitenfläche 122 geleitet. Das dort austretende erwärmte Kühlmedium wird dann wieder einem äußeren Kühlkreislauf mit Wärmeaustauscher und Pumpe zugeführt, siehe Pfeile 250 und 252. Demzufolge bleibt das Kühlmedium bei dem ersten Ausführungsbeispiel im gesamten Kühlkreislauf in der flüssigen Phase.

Experimentelle Daten belegen, dass bei einer Porenlänge von 500 µm und 8 µm Durchmesser sowie bei einem Abstand A3 von 12 µm mit einem Druck von beispielsweise 1 bar z.B. eine Wassermenge von 10 ml pro Sekunde und cm² Chipfläche gepumpt werden kann. Bei einer Chipleistung von 1000 Watt pro cm² würde dies zu einer Erwärmung von Kühlwasser von etwa 25°C führen. Dies ist zwar in etwa gleich der zusätzlichen Erwärmung, die man bei einem 350 µm dicken Siliziumchip bei derselben Leistung aufgrund des thermischen Widerstandes des Substrats 112 hätte. Eine Performancesteigerung durch die direkte Kühlung mittels Substratporen wäre also vom Substrat 112 her betrachtet erst bei sehr hohen Leistungsdichten zu erwarten, da Silizium ein sehr guter Wärmeleiter ist. Tatsächlich ist eine Direktkühlung über die Hauptkanäle 150 bis 156 und die Querkanäle 160 bis 196 auch schon bei sehr viel niedrigeren Leistungsdichten lohnend, da eines der Hauptprobleme beim Packaging der Wärmeübergang vom Silizium in das darunterliegende Metall oder Keramiksubstrat ist. Dieser Wärmeübergang wird durch die vielfach vergrößerte Oberfläche der Hauptkanäle 150 bis 156 und der Querkanäle 160 bis 196 im Vergleich zu der Oberfläche der Bodenfläche 126 und den damit verbundenen guten Wärmeübergang auf das Kühlmedium nachrangig. Beispielsweise ist die Oberfläche der Hauptkanäle 150 bis 156 und der Querkanäle 160 bis 196 mehr als hundert mal so groß wie die Deckfläche 114 bzw. die Bodenfläche 126 des Substrats 112.

Bei einem anderen Ausführungsbeispiel mit äußerer Pumpe wird das Kühlmedium in die Hauptkanäle 150 bis 156 eingepumpt und strömt aus den Querkanälen 160 bis 196 aus.

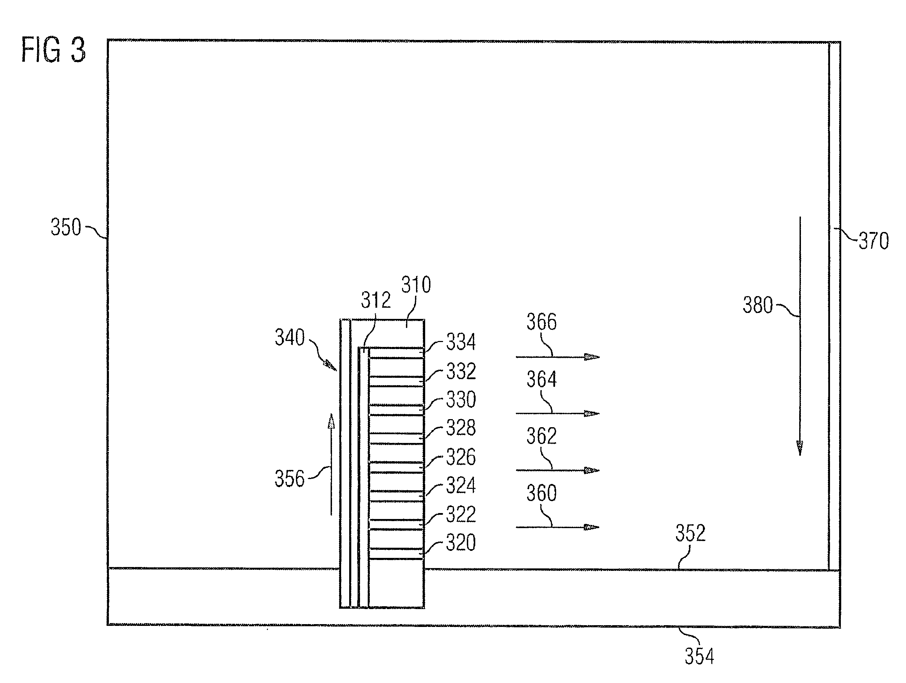

Figur 3 zeigt eine integrierte Schaltungsanordnung 310, die Hauptkanäle 312 und Querkanäle 320 bis 334 enthält. Die Abmessungen und der Abstand der Hauptkanäle 312 und der Querkanäle 320 bis 324 entsprechen den oben an Hand der Figur 2 erläuterten Abmessungen. An einer Deckfläche 340 sind die integrierten Bauelemente angeordnet. Die versiegelte oder auf andere Art vor dem Wasser geschützte integrierte Schaltungsanordnung 310 befindet sich in einem luft- und wasserdichten Gehäuse 350, dessen Volumen das Volumen des Substrats der integrierten Schaltungsanordnung 310 um ein Mehrfaches überschreitet. Beispielsweise hat das Gehäuse 350 eine Abmessung von 7 cm x 7 cm x 7 cm währende die Schaltungsanordnung 310 Abmessungen von 2 cm x 2 cm x 1mm hat. Die in Figur 3 dargestellte Position ist die Arbeitsposition, in der sich eine Kühlflüssigkeit 352, beispielsweise Wasser, an einem Boden 354 des Gehäuses 350 auf Grund der Schwerkraft sammelt. Das Wasser strömt aufgrund von Kapillarkräften in den Hauptkanälen 321 entgegen der Schwerkraft nach oben, siehe Pfeil 356. Aufgrund der an der Deckfläche 340 herrschenden Hitze den Querkanälen 320 bis 334 Wasserdampf nach außen, siehe Pfeile 360 bis 366. Insbesondere verdampft die Kühlflüssigkeit erst beim Austritt aus den Querkanälen 320 bis 334. Der Wasserdampf kondensiert an einer gekühlten Seitenfläche 370 des Gehäuses 350. Das kondensierte Wasser läuft aufgrund der Schwerkraft wieder zum Boden 354, siehe Pfeil 380. Auf Grund der Vielzahl von Querkanälen 320 bis 334 ist einer Große Verdampfungsfläche vorhanden.

Bei einem anderen Ausführungsbeispiel haben die Hauptkanäle 312 den gleichen Querschnitt wie die Querkanäle 320 bis 334.

Bei einem weiteren Ausführungsbeispiel werden die an Hand der Figur 2 erläuterten Abmessungen beibehalten, jedoch wird die integrierte Schaltungsanordnung 310 um 90° um eine aus der Blattebene zeigende Achse nach rechts gedreht, d.h. parallel zum Boden 354 angeordnet. Bei diesem Ausführungsbeispiel liegen Eintrittsöffnungen der Querkanäle 320 bis 334 in der Nähe der Bodenfläche 354 und das flüssige Wasser 352 strömt aufgrund der Kapillarwirkung zuerst durch die Querkanäle 320 bis 334 und tritt dann als Wasserdampf durch die Hauptkanäle 312 nach außen. Insbesondere verdampft die Kühlflüssigkeit erst beim Austritt aus den Hauptkanälen 312.

Bei den an Hand der Figur 3 erläuterten Ausführungsbeispielen wirken die Hauptkanäle 312 bzw. die Querkanäle 320 bis 324 als Kapillarsystem einer sogenannten heatpipe, die ohne zusätzliche äußere Pumpleistung Wärme abtransportiert. Der Transport des Kühlmittels wird über die Kapillarkräfte in den Hauptkanälen 312 bzw. in den Querkanälen 320 bis 324 bewirkt. Das Kühlmedium verdampft und der Dampf verlässt das Substrat über die Querkanäle 320 bis 324 an der Rückseite bzw. über die Seitenöffnungen der Hauptkanäle 312. Der Dampf kondensiert dann an der Seitenfläche 370 oder auch an mehreren Seitenflächen 370 bzw. auch an der Deckfläche 350.

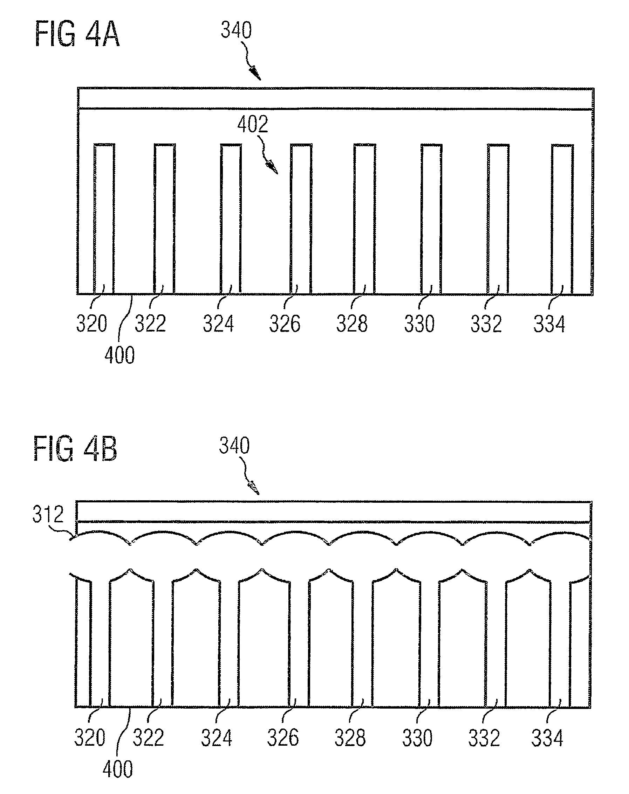

Die Figuren 4A und 4B zeigen Herstellungsstufen bei der Herstellung der Querkanäle 320 bis 334 sowie bei der Herstellung des Hauptkanals 312. Zur Herstellung wird eine elektrolytische Ätzung von Silizium in Flusssäure HF verwendet. Zur Erzeugung der Makroporen wird n-dotiertes Silizium verwendet. Der Abstand der Kanäle wird dabei über die Dotierkonzentration festgelegt. Falls für die elektronischen Bauelemente ein p-dotiertes Substrat notwendig ist, so wird dies für die Bauelementeschicht durch Epitaxie oder Ionenimplantation auf bzw. im n-Substrat erzeugt.

Wie in Figur 4A dargestellt, werden zunächst die Querkanäle 320 bis 334 von einer Rückseite 400 des Siliziumsubstrats her elektrochemisch geätzt. Typische Werte für Porenabstand und Durchmesser auf 100 Ohm x cm n-Substraten haben z.B. 10 µm Abstand und 5 µm Durchmesser. Mit anderen Worten ausgedrückt, muss die Dotierung des Substrats 402 auf die Dichte der Querkanäle 320 bis 334 abgestimmt werden, um zu vermeiden, dass die Querkanäle 320 bis 334 mit unterschiedlicher Tiefe in das Substrat 402 geätzt werden.

Zunächst werden mit Hilfe eines fotolithografischen Prozesses oder auf andere Weise Ätzgruben geätzt, um die Ausprägung von Feldspitzen für den Start des elektrochemischen Abtragen an definierten Stellen zu ermöglichen. Gleich zu Beginn, d.h. an der Rückseite 400, werden dann die Poren noch etwas enger geätzt, was in Figur 4A nicht dargestellt ist, um sie später mit einer Opferschicht z.B. aus polykristallinem Silizium versiegeln zu können. Dies ist angebracht, damit beim nachträglichen Prozessieren der Bauelemente keine Verunreinigungen in die Querkanäle 320 bis 324 und auch nicht in die Hauptkanäle 312 gelangen. Am Ende der vertikalen Porenätzung, etwa 30 µm von den Bauelementen entfernt, werden die Kanäle durch Erhöhung des Elektrolysestroms dann auf 15 bis 20 µm vergrößert, so dass sie sich berühren und entsprechend ihrer Anordnung durchgehende horizontale Kanäle mit einer Verbindung zur Außenseite entstehen, siehe Figur 4B. Eine Modulation der Kanaldurchmesser über den Elektrolytstrom ist beispielsweise in dem Buch "Electrochemistry of Silicon", V. Lehmann, erläutert.

Nach dem Ätzen der Querkanäle 320 bis 334 und der Hauptkanäle 312 wird bei einem anderen Ausführungsbeispiel eine isotrope Siliziumätzung z.B. mit Flusssäure HF und Salpetersäure HNO₃ durchgeführt, um die Querkanäle 320 bis 334 und die Hauptkanäle 312 zu erweitern. Dadurch lassen sich höhere Durchflussraten erzielen. Eine obere Grenze stellt die mechanische Stabilität des Substrats dar.

Wie oben erwähnt, werden vor dem Prozessieren der Bauelemente die Poren der Querkanäle 320 bis 334 und der Hauptkanäle 312 in einem oberflächennahen Bereich durch Abscheidung einer Opferschicht verschlossen. Die Opferschicht wird am Ende des Gesamtprozesses durch Polieren oder Rückätzen entfernt, so dass Eintrittsöffnungen und Austrittsöffnungen der Querkanäle 320 bis 334 bzw. der Hauptkanäle 312 wieder freiliegen.

Aus dem mehrmals erwähnten Buch "Electrochemistry of Silicon" sind in der ersten Auflage insbesondere relevant:
- die Seite 112, auf der das Abstimmen zwischen Porendichte und Dotierung erläutert ist, sowie
- die Seite 200, auf der die Modulation der Kanalbreite erläutert ist, die zum Erzeugen der Hauptkanäle am Ende der Querkanäle erforderlich ist.

Bei einem anderen Ausführungsbeispiel ist auf der Deckfläche nur ein Leistungshalbleiterbauelement angeordnet. Alternativ sind auf der Deckfläche mehrere Halbleiterbauelemente angeordnet, z.B. Halbleiterbauelemente die jeweils Ströme größer als 1 Ampere oder größer als 10 Ampere schalten.

## Patentansprüche

1. Integrierte Kühl-Schaltungsanordnung (110),
mit einem Substrat (112), dessen eine Oberfläche (114) eine Hauptfläche bildet,
mit einer Vielzahl von an der Hauptfläche (114) angeordneten integrierten elektronischen Bauelementen (116), wobei die Bauelemente (116) entweder im Substrat oder gemäß der SOI-Technik durch ein elektrisch isolierendes Gebiet vom Substrat (112) getrennt angeordnet sind,
und mit einer Vielzahl von im Substrat (112) ausgebildeten Hauptkanälen (150 bis 156), die entlang der Hauptfläche (114) angeordnet sind,
wobei die Hauptkanäle (150 bis 156) jeweils quer zu ihrer Längsachse vollständig von dem Substrat (112) umgeben sind, **dadurch gekennzeichnet, dass** das Substrat (112) vollständig aus einkristallinem Material besteht,
dass eine Vielzahl von quer zu den Hauptkanälen (150 bis 156) angeordneten Querkanälen (160 bis 196) vorhanden sind, die jeweils in mindestens einen Hauptkanal (150 bis 156) münden, und dass mehr als zehn Querkanäle in einen Hauptkanal münden.

2. Schaltungsanordnung (110) nach Anspruch 1, **dadurch gekennzeichnet, dass** die Querkanäle (160 bis 196) eine Länge größer 100 µm oder größer 200 µm haben,
wobei die Länge (L2) der Querkanäle (160 bis 196) vorzugsweise mehr als 3/4 der Dicke (D1) des Substrats (112) beträgt.

3. Schaltungsanordnung (110) nach Anspruch 1 oder 2, **dadurch gekennzeichnet, dass** die Längsachsen der Hauptkanäle (150 bis 156) parallel zueinander ausgerichtet sind,
und dass die Längsachsen der Querkanäle (160 bis 196) parallel zueinander ausgerichtet sind,
wobei die Längsachsen der Querkanäle (160 bis 196) vorzugsweise in Normalenrichtung der Hauptfläche (114) liegen.

4. Schaltungsanordnung (110) nach einem der vorhergehenden Ansprüche, **dadurch gekennzeichnet, dass** einander gegenüberliegende Seiten eines Hauptkanals (150 bis 156) einen Abstand (D2) kleiner als 40 µm oder kleiner 10 µm haben, vorzugsweise entlang des gesamten Hauptkanals (150 bis 156),
und/oder dass einander gegenüberliegende Seiten eines Querkanals (160 bis 196) einen Abstand (D3) kleiner als 40 µm oder kleiner als 10 µm haben, vorzugsweise entlang des gesamten Querkanals (160 bis 196),
und/oder dass der minimale Abstand (A2) der Ränder einander benachbarter Hauptkanäle (150 bis 156) kleiner als 40 µm oder kleiner als 20 µm oder kleiner als 10 µm ist,
und/oder dass der minimale Abstand (A3) der Ränder einander benachbarter Querkanäle (160 bis 196) kleiner als 40 µm oder kleiner als 20 µm oder kleiner als 10 µm ist.

5. Schaltungsanordnung (110) nach einem der vorhergehenden Ansprüche, **dadurch gekennzeichnet, dass** ein Rand eines Hauptkanals (150 bis 156) weniger als 50 µm oder weniger als 10 µm von der Hauptfläche (114) entfernt liegt.

6. Schaltungsanordnung (110) nach einem der vorhergehenden Ansprüche, **gekennzeichnet durch** ein das Substrat (112) umgebendes Gehäuse (350), in dem sich ein flüssiges Kühlmedium (352) befindet.

7. Schaltungsanordnung (110) nach Anspruch 6, **dadurch gekennzeichnet, dass** die Hauptkanäle (150 bis 156) oder die Querkanäle (160 bis 196) einen so kleinen Durchmesser (D2, D3) haben, dass das Kühlmedium (352) durch Kapillarkräfte transportiert wird,
und dass das Gehäuse (350) vorzugsweise keine Pumpe zum Transportieren des Kühlmittels (352) und auch keine Öffnungen zum Eintritt oder Austritt des Kühlmittels (352) enthält,
und dass das Gehäuse (350) eine Kondensiervorrichtung (370) enthält oder dass mit dem Gehäuse (350) eine Kondensiervorrichtung (370) verbunden ist, die gasförmiges Kühlmedium zu flüssigem Kühlmedium (352) kondensiert, insbesondere eine gekühlte Kondensorfläche (370).

8. Schaltungsanordnung (110) nach einem der Ansprüche 1 bis 5, **gekennzeichnet durch** ein mit den Hauptkanälen (150 bis 156) und/oder den Querkanälen (160 bis 196) verbundenen Pumpsystem zum Transport des Kühlmittels (352) mit Hilfe einer Pumpe, die insbesondere außerhalb des Substrats (112) angeordnet ist.

9. Schaltungsanordnung (110) nach einem der vorhergehenden Ansprüche, **dadurch gekennzeichnet, dass** das Substrat (112) in Bereichen der Hauptkanäle (150 bis 156) und der Querkanäle (160 bis 196) n-dotiert ist.

10. Verfahren zum Kühlen einer Schaltungsanordnung (110) nach einem der vorhergehenden Ansprüche, **dadurch gekennzeichnet, dass** eine Kühlflüssigkeit (352) aus einer Sammelwanne durch Kapillarkräfte in den Querkanälen (160 bis 196) bis zu einem Hauptkanal (150 bis 156) transportiert wird,
dass Kühlmitteldampf aus den Hauptkanälen (150 bis 156) austritt,
und dass der Kühlmitteldampf mit Hilfe einer Kondensiervorrichtung (370) zu flüssigem Kühlmittel (352) kondensiert, das wieder in die Sammelwanne eingeleitet wird.

11. Verfahren zum Kühlen einer Schaltungsanordnung nach einem der Ansprüche 1 bis 9, **dadurch gekennzeichnet, dass** eine Kühlflüssigkeit (352) aus einer Sammelwanne durch Kapillarkräfte in den Hauptkanälen (150 bis 156) bis zu den Querkanälen (160 bis 196) transportiert wird, dass Kühlmitteldampf aus den Querkanälen (160 bis 196) austritt,
und dass der Kühlmitteldampf mit Hilfe einer Kondensiervorrichtung (370) zu flüssigem Kühlmittel (352) kondensiert wird, das wieder in die Sammelwanne eingeleitet wird.

12. Verfahren zum Herstellen einer integrierten Kühl-Schaltungsanordnung (110), insbesondere einer integrierten Kühl-Schaltungsanordnung nach einem der Ansprüche 1 bis 9, mit den ohne Beschränkung durch die angegebene Reihenfolge ausgeführten Verfahrensschritten:
Bereitstellen eines Substrats (112), wobei das Substrat (112) Vollständig aus einkristallinem material besteht,
Einbringen von Hauptkanälen (150 bis 156) in das Substrat (112), wobei die Hauptkanäle (150 bis 156) jeweils quer zu ihrer Lärgsachse vollständig von den Substrat (112) umgeben sind, und wobei die Längsachsen der Hauptkanäle (150 bis 156) parallel zu einer Hauptfläche (114) des Substrats (112) liegen,
Einbringen von Querkanälen (160 bis 196) in das Substrat (112), wobei die Querkanäle (160 bis 196) quer zu der Hauptfläche (114) liegen,
Ausbilden von Mündungen (200 bis 206) der Querkanäle (160 bis 196) in die Hauptkanäle (150 bis 156) beim Einbringen der Querkanäle (160 bis 196) oder beim Einbringen der Hauptkanäle (150 bis 156), wobei nehr als zehr Querkanäle in einen Hauptkanal Münden, Erzeugen von integrierten elektronischen Bauelementen (116) in der Hauptfläche (114) oder an der Hauptfläche (114),
wobei zuerst die Querkanäle (160 bis 196) und danach die Hauptkanäle (150 bis 156) durch Aufweitung von Querkanälen (160 bis 196) erzeugt werden.

13. Verfahren nach Anspruch 12, **dadurch gekennzeichnet, dass** die integrierten elektronischen Bauelemente (114) nach dem Einbringen der Hauptkanäle (150 bis 156) und der Querkanäle (160 bis 196) an der Hauptfläche (114) erzeugt werden,
und dass vorzugsweise die Öffnungen der Hauptkanäle (150 bis 156) und der Querkanäle (160 bis 196) vor dem Erzeugen der integrierten elektronischen Bauelemente (116) verschlossen werden.

14. Verfahren nach Anspruch 12 oder 13, **dadurch gekennzeichnet, dass** in einem elektrochemischen Abtragungsprozess oder einem anisotropen Ätzprozess zuerst die Querkanäle (160 bis 196) und danach die Hauptkanäle (150 bis 156) durch Aufweitung von Querkanälen (160 bis 196) erzeugt werden.

15. Verfahren nach einem der Ansprüche 12 bis 14, **gekennzeichnet durch** den Schritt:
gleichzeitiges Aufweiten der Hauptkanäle (150 bis 156) und der Querkanäle (160 bis 196) nach dem Ausbilden der Mündungen (200 bis 206), vorzugsweise mit Hilfe eines isotropen Ätzprozesses.

16. Verfahren nach einem der Ansprüche 12 bis 15, **dadurch gekennzeichnet, dass** zum Ausbilden der Hauptkanäle (150 bis 156) und der Querkanäle (160 bis 196) Flusssäure in einem elektrochemischen Ätzverfahren verwendet wird,
und dass vorzugsweise das Substrat (112) während des elektrochemischen Ätzens an ein positiveres Potential als die Flusssäure angelegt wird,
und dass vorzugsweise n-dotiertes Siliziumsubstrat (112) verwendet wird.

## Claims

1. Integrated coolant circuit arrangement (110),
having a substrate (112), one surface (114) of which forms a main area,
having a multiplicity of integrated electronic components (116) arranged at the main area (114); the components (116) being arranged either in the substrate or in a manner isolated from the substrate (112) by an electrically insulating region in accordance with the SOI technique,
and having a multiplicity of main channels (150 to 156) which are formed in the substrate (112) and are arranged along the main area (114),
the main channels (150 to 156) being completely surrounded by the substrate (112) in each case transversely with respect to their longitudinal axis,
**characterized in that** the substrate (112) is completely composed of monocrystalline material, **in that** a multiplicity of transverse channels (160 to 196) arranged transversely with respect to the main channels (150 to 156) are present, which transverse channels in each case open into at least one main channel (150 to 156), and **in that** more than ten transverse channels open into a main channel.

2. Circuit arrangement (110) according to Claim 1, **characterized in that** the transverse channels (160 to 196) have a length of greater than 100 µm or greater than 200 µm, the length (L2) of the transverse channels (160 to 196) preferably being more than 3/4 of the thickness (D1) of the substrate (112).

3. Circuit arrangement (110) according to Claim 1 or 2, **characterized in that** the longitudinal axes of the main channels (150 to 156) are oriented parallel to one another,
and **in that** the longitudinal axes of the transverse channels (160 to 196) are oriented parallel to one another,
the longitudinal axes of the transverse channels (160 to 196) preferably lying in the direction of the normal to the main area (114).

4. Circuit arrangement (110) according to one of the preceding claims, **characterized in that** mutually opposite sides of a main channel (150 to 156) have a distance (D2) of less than 40 µm or less than 10 µm, preferably along the entire main channel (150 to 156),
and/or **in that** mutually opposite sides of a transverse channel (160 to 196) have a distance (D3) of less than 40 µm or less than 10 µm, preferably along the entire transverse channel (160 to 196),
and/or **in that** the minimum distance (A2) between the edges of mutually adjacent main channels (150 to 156) is less than 40 µm or less than 20 µm or less than 10 µm,
and/or **in that** the minimum distance (A3) between the edges of mutually adjacent transverse channels (160 to 196) is less than 40 µm or less than 20 µm or less than 10 µm.

5. Circuit arrangement (110) according to one of the preceding claims, **characterized in that** an edge of a main channel (150 to 156) lies less than 50 µm or less than 10 µm away from the main area (114).

6. Circuit arrangement (110) according to one of the preceding claims, **characterized by** a housing (350) surrounding the substrate (112), a liquid cooling medium (352) being situated in said housing.

7. Circuit arrangement (110) according to Claim 6,
**characterized in that** the main channels (150 to 156) or the transverse channels (160 to 196) have such a small diameter (D2, D3) that the cooling medium (352) is transported by capillary forces,
and **in that** the housing (350) preferably does not contain a pump for transporting the coolant (352) and also does not contain any orifices for the entry or exit of the coolant (352),
and **in that** the housing (350) contains a condensing device (370) or **in that** a condensing device (370) is connected to the housing (350), said condensing device condensing gaseous cooling medium to form liquid cooling medium (352), in particular a cooled condenser area (370).

8. Circuit arrangement (110) according to one of Claims 1 to 5, **characterized by** a pump system connected to the main channels (150 to 156) and/or the transverse channels (160 to 196) and serving for transporting the coolant (352) with the aid of a pump that is arranged in particular outside the substrate (112).

9. Circuit arrangement (110) according to one of the preceding claims, **characterized in that** the substrate (112) is n-doped in regions of the main channels (150 to 156) and of the transverse channels (160 to 196).

10. Method for cooling a circuit arrangement (110) according to one of the preceding claims, **characterized in that** a cooling liquid (352) is transported from a collecting trough by capillary forces in the transverse channels (160 to 196) as far as a main channel (150 to 156),
**in that** coolant vapor exits from the main channels (150 to 156),
and **in that** the coolant vapor is condensed with the aid of a condensing device (370) to form liquid coolant (352), which is introduced into the collecting trough again.

11. Method for cooling a circuit arrangement according to one of Claims 1 to 9, **characterized in that** a cooling liquid (352) is transported from a collecting trough by capillary forces in the main channels (150 to 156) as far as the transverse channels (160 to 196),
**in that** coolant vapor exits from the transverse channels (160 to 196),
and **in that** the coolant vapor is condensed with the aid of a condensing device (370) to form liquid coolant (352), which is introduced into the collecting trough again.

12. Method for producing an integrated coolant circuit arrangement (110), in particular an integrated coolant circuit arrangement according to one of Claims 1 to 9, having the following method steps that are implemented without restriction by the order specified:
provision of a substrate (112), the substrate (112) being completely composed of monocrystalline material,
introduction of main channels (150 to 156) into the substrate (112), the main channels (150 to 156) being completely surrounded by the substrate (112) in each case transversely with respect to their longitudinal axis, and the longitudinal axes of the main channels (150 to 156) lying parallel to a main area (114) of the substrate (112),
introduction of transverse channels (160 to 196) into the substrate (112), the transverse channels (160 to 196) lying transversely with respect to the main area (114),
formation of openings (200 to 206) of the transverse channels (160 to 196) into the main channels (150 to 156) during the introduction of the transverse channels (160 to 196) or during the introduction of the main channels (150 to 156), more than ten transverse channels opening into a main channel,
production of integrated electronic components (116) in the main area (114) or at the main area (114),
in which case firstly the transverse channels (160 to 196) are produced and then the main channels (150 to 156) are produced by expanding transverse channels (160 to 196).

13. Method according to Claim 12, **characterized in that** the integrated electronic components (114) are produced after the introduction of the main channels (150 to 156) and of the transverse channels (160 to 196) at the main area (114),
and **in that** the orifices of the main channels (150 to 156) and of the transverse channels (160 to 196) are preferably closed off prior to the production of the integrated electronic components (116).

14. Method according to Claim 12 or 13, **characterized**
**in that**, in an electrochemical removal process or an anisotropic etching process, firstly the transverse channels (160 to 196) are produced and then the main channels (150 to 156) are produced by expanding transverse channels (160 to 196).

15. Method according to one of claims 12 to 14, **characterized by** the step of:
simultaneously expanding the main channels (150 to 156) and the transverse channels (160 to 196) after the formation of the openings (200 to 206), preferably with the aid of an isotropic etching process.

16. Method according to one of Claims 12 to 15, **characterized in that** hydrofluoric acid is used in an electrochemical etching method for the purpose of forming the main channels (150 to 156) and the transverse channels (160 to 196),
and **in that** the substrate (112) is preferably connected to a more positive potential than the hydrofluoric acid during the electrochemical etching,
and **in that** an n-doped silicon substrate (112) is preferably used.

## Revendications

1. Ensemble circuit ( 110 ) intégré à refroidissement,
comprenant un substrat ( 112 ), dont une surface ( 114 ) forme une surface principale,
comprenant une pluralité de composants ( 116 ) électroniques intégrés disposés sur la surface ( 114 ) principale, les composants ( 116 ) étant disposés soit dans le substrat, soit suivant la technique SOI, en étant séparés du substrat ( 112 ) par un domaine isolant du point de vue électrique,
et comprenant une pluralité de canaux ( 150 à 156 ) principaux qui sont formés dans le substrat ( 112 ) et qui sont disposés le long de la surface ( 114 ) principale,
dans lequel les canaux ( 150 à 156 ) principaux sont entourés, respectivement, transversalement à leur axe longitudinal entièrement par le substrat ( 112 ),
**caractérisé en ce que** le substrat ( 112 ) est entièrement en matériau monocristallin, **en ce qu'**il y a une pluralité de canaux ( 160 à 196 ) transversaux qui sont disposés transversalement aux canaux ( 150 à 156 ) principaux et qui débouchent, respectivement, dans au moins un canal ( 150 à 156 ) principal et **en ce que** plus de dix canaux transversaux débouchent dans un canal principal.

2. Ensemble circuit ( 110 ) suivant la revendication 1, **caractérisé en ce que** les canaux ( 160 à 196 ) transversaux ont une longueur plus grande que 100 µm ou plus grande que 200 µm, la longueur ( L2 ) des canaux 160 à 196 ) transversaux représentant, de préférence, plus des ¾ de l'épaisseur ( D1 ) du substrat ( 112 ).

3. Ensemble circuit ( 110 ) suivant la revendication 1 ou 2, **caractérisé en ce que** les axes longitudinaux des canaux ( 150 à 156 ) principaux sont parallèles entre eux
et **en ce que** les axes longitudinaux des canaux ( 160 à 196 ) transversaux sont parallèles entre eux,
les axes longitudinaux des canaux ( 160 à 196 ) transversaux étant, de préférence, dans la direction normale à la surface ( 114 ) principale.

4. Ensemble circuit ( 110 ) suivant l'une des revendications précédentes, **caractérisé en ce que** des côtés opposés l'un à l'autre d'un canal ( 150 à 156 ) principal sont à une distance ( D2 ) plus petite que 40 µm ou plus petite que 10 µm, de préférence le long de tout le canal ( 150 à 156 ) principal
et/ou **en ce que** des côtés opposés l'un à l'autre d'un canal ( 160 à 196 ) transversal sont à distance ( D3 ) plus petite que 40 µm ou plus petite que 10 µm, de préférence le long de tout le canal ( 160 à 196 ) transversal
et/ou **en ce que** la distance ( A2 ) minium des bords des canaux ( 150 à 156 ) principaux voisins l'un de l'autre est plus petite que 40 µm ou plus petite que 20 µm ou plus petite que 10 µm
et/ou **en ce que** la distance ( A3 ) minimum des bords des canaux ( 160 à 196 ) transversaux voisins est plus petite que 40 µm ou plus petite que 20 µm ou plus petite que 10 µm.

5. Ensemble circuit ( 110 ) suivant l'une des revendications précédentes, **caractérisé en ce qu'**un bord d'un canal ( 150 à 156 ) principal est éloigné de moins de 50 µm ou de moins de 10 µm de la surface ( 114 ) principale.

6. Ensemble circuit ( 110 ) suivant l'une des revendications précédentes, **caractérisé par** un boîtier ( 350 ) qui entoure le substrat ( 112 ) et dans lequel se trouve un fluide ( 352 ) liquide de refroidissement.

7. Ensemble circuit ( 110 ) suivant la revendication 6, **caractérisé en ce que** les canaux ( 150 à 156 ) principaux ou les canaux ( 160 à 196 ) transversaux ont un diamètre ( D2, D3 ) si petit que le fluide ( 352 ) de refroidissement est transporté par des forces de capillarité
et **en ce que** le boîtier ( 350 ) ne comporte, de préférence, pas de pompe de transport du fluide ( 352 ) de refroidissement, ni non plus d'ouverture d'entrée ou de sortie du fluide ( 352 ) de refroidissement
et **en ce que** le boîtier ( 350 ) contient un dispositif ( 370 ) de condensation ou **en ce qu'**au boîtier ( 350 ) est relié un dispositif ( 3720 ) de condensation, qui condense du fluide de refroidissement gazeux en du fluide ( 352 ) de refroidissement liquide, notamment une surface ( 370 ) de condenseur refroidie.

8. Ensemble circuit ( 110 ) suivant l'une des revendications 1 à 5, **caractérisé par** un système de pompage communiquant avec les canaux ( 150 à 156 ) principaux et/ou avec les canaux ( 160 à 196 ) transversaux de transport du fluide ( 352 ) de refroidissement à l'aide d'une pompe qui est disposée notamment à l'extérieur du substrat ( 112 ).

9. Ensemble circuit ( 110 ) suivant l'une des revendications précédentes, **caractérisé en ce que** le substrat ( 112 ) est à dopage du type n dans des parties des canaux ( 150 à 156 ) principaux et des canaux ( 160 à 196 ) transversaux.

10. Procédé de refroidissement d'un ensemble circuit ( 110 ) suivant l'une des revendications précédentes, **caractérisé en ce que** l'on transporte un liquide ( 352 ) de refroidissement d'une cuvette collectrice par des forces de capillarité dans les canaux ( 160 à 196 ) transversaux jusqu'à un canal ( 150 à 156 ) principal,
**en ce que** l'on fait sortir de la vapeur du fluide de refroidissement des canaux ( 150 à 156 ) principaux
et **en ce que** l'on condense la vapeur du fluide de refroidissement à l'aide d'un dispositif ( 370 ) de condensation en du fluide ( 352 ) de refroidissement liquide que l'on retourne à la cuvette collectrice.

11. Procédé de refroidissement d'un ensemble circuit ( 110 ) suivant l'une des revendications 1 à 9, **caractérisé en ce que** l'on transporte un liquide ( 352 ) de refroidissement d'une cuvette collectrice par des forces de capillarité dans les canaux ( 150 à 156 ) principaux jusqu'aux canaux ( 160 à 196 ) transversaux,
**en ce que** l'on fait sortir de la vapeur du fluide de refroidissement des canaux ( 160 à 196 ) transversaux
et **en ce que** l'on condense la vapeur du fluide de refroidissement à l'aide d'un dispositif ( 370 ) de condensation en du fluide ( 352 ) de refroidissement liquide que l'on retourne dans la cuvette collectrice.

12. Procédé de production d'un ensemble de circuit ( 110 ) intégré à refroidissement, notamment d'un ensemble circuit intégré à refroidissement suivant l'une des revendications 1 à 9 par les stades de procédé réalisés sans limitation par la succession mentionnée :
on se procure un substrat ( 112 ), le substrat ( 112 ) étant entièrement en un matériau monocristallin,
on ménage des canaux ( 150 à 156 ) principaux dans le substrat ( 112 ), les canaux ( 150 à 156 ) principaux étant entourés, respectivement, entièrement par le substrat ( 112 ) transversalement à leur axe longitudinal et les axes longitudinaux des canaux ( 150 à 156 ) principaux étant parallèles à une surface ( 114 ) principale du substrat ( 112 ),
on ménage des canaux ( 160 à 196 ) transversaux dans le substrat ( 112 ), les canaux ( 160 à 196 ) transversaux étant transversaux à la surface ( 114 ) principale,
on forme des embouchures ( 200 à 206 ) des canaux ( 160 à 196 ) transversaux dans les canaux ( 150 à 156 ) principaux lorsque l'on ménage les canaux ( 160 à 196 ) transversaux ou lorsque l'on ménage les canaux ( 150 à 156 ) principaux, plus de dix canaux transversaux débouchant dans un canal principal,
on produit des composants ( 116 ) électroniques intégrés dans la surface ( 114 ) principale ou sur la surface ( 114 ) principale en produisant d'abord les canaux ( 160 à 196 ) transversaux et ensuite les canaux ( 150 à 156 ) principaux, en élargissant les canaux ( 160 à 196 ) transversaux.

13. Procédé suivant la revendication 12, **caractérisé en ce que** l'on produit les composants ( 114 ) électroniques intégrés sur la surface principale, après avoir ménagé les canaux ( 150 à 156 ) principaux et les canaux ( 160 à 196 ) transversaux
et **en ce que**, de préférence, l'on ferme les ouvertures des canaux ( 150 à 156 ) principaux et des canaux ( 160 à 196 ) transversaux avant la production des composants ( 116 ) électroniques intégrés.

14. Procédé suivant la revendication 12 ou 13, **caractérisé en ce que** l'on produit par une opération électrochimique d'enlèvement de matière ou par une opération d'attaque chimique d'abord les canaux ( 160 à 196 ) transversaux, puis les canaux ( 150 à 156 ) principaux en élargissant des canaux ( 160 à 196 ) transversaux.

15. Procédé suivant l'une des revendications 12 à 14, **caractérisé par** le stade dans lequel :
on élargit en même temps les canaux ( 150 à 156 ) principaux et les canaux ( 160 à 196 ) transversaux après avoir formé les embouchures ( 200 à 206 ), de préférence à l'aide d'un procédé d'attaque isotrope.

16. Procédé suivant l'une des revendications 12 à 15, **caractérisé en ce que** pour former les canaux ( 150 à 156 ) principaux et les canaux ( 160 à 196 ) transversaux, on utilise de l'acide fluorhydrique dans un procédé d'attaque électrochimique,
et **en ce que** l'on met de préférence le substrat pendant l'attaque électrochimique à un potentiel plus positif que l'acide fluorhydrique,
et **en ce que** l'on utilise de préférence un substrat ( 112 ) en silicium à dopage du type n.
